# EUROPEAN PATENT APPLICATION

(11) **EP 4 485 528 A1**
(43) Date of publication of application: **01.01.2025**
(21) Application number: 23182195.0
(22) Date of filing: 28.06.2023
(51) Int. Cl.: H01L 23/495, H01L 21/56

(54) **A SEMICONDUCTOR DEVICE AS WELL AS A METHOD FOR MANUFACTURING SUCH SEMICONDUCTOR DEVICE**

(71) Applicant: Nexperia B.V., 6534 AB Nijmegen (NL)
(72) Inventor: Lam, Kan Wae, Nijmegen (NL); Walczyk, Sven, Nijmegen (NL); Hor, Wai Hung William, Hong Kong (HK); Flauta, Randolph Estal, Hong Kong (HK)
(74) Representative: Pjanovic, Ilija

(57) **Abstract**

The present disclosure proposes a semiconductor device and a method of manufacturing thereof, the semiconductor device comprising a die having a first side and a second side, wherein the die comprises, on a perimeter of the second side, a plurality of die terminals, a central pad having an inner side and an outer side, wherein the central pad comprises an at least one notch, a mold, an non-conductive adhesive layer, wires, at least two lead terminals having an inner side and an outer side, wherein the at least one lead terminal is configured as a long lead terminal. Each of the long lead terminals is placed in the notch. The non-conductive adhesive layer is placed on at least part of the inner side of the central pad and on at least part of the inner side of each of the long lead terminals.

## Description

### TECHNICAL FIELD

The present disclosure relates to the field of semiconductor devices as well as a method for manufacturing semiconductor devices.

### BACKGROUND OF THE DISCLOSURE

When manufacturing a semiconductor device it is known that a die of a semiconductor device may be mounted on a lead frame die pad and electrically connected to the electrical path by wire bonding. The die bond-pad positions are located near the die edge for easy assembly. The bond pads of dies larger than the die pad are located on a non-full metal area (half etched lead frame). A wire bond process requires a good die support - a die, which is not fully supported during a manufacturing process, may be damaged.

Prior art document US8110903B2 discloses an improved Quad Flat No-Lead package is described. The package is formed by encapsulating a die mounted on a lead frame with a moulding compound using a mould chase. The mould chase comprises a number of internal projections which form openings in the mould compound to expose regions of the lead frame. These exposed regions of the lead frame may then be used for soldering the package to a substrate. The arrangement of the openings may be designed such that each aperture is the same shape and size and/or that the apertures are arranged in multiple rows on the underside of the package.

Prior art document US8035204B2 discloses a method for fabricating large die package structures is provided wherein at least portions of the lead tips of at least a plurality of lead fingers of a lead frame are electrically insulated. A die is positioned on the electrically insulated lead tips. The die is electrically connected to at least a plurality of the lead fingers.

Accordingly, it is a goal of the present disclosure to provide an improved method of manufacturing a semiconductor device with a die which surface area is greater than a surface area of a central pad such that a risk of damaging a die is minimalised.

### SUMMARY OF THE DISCLOSURE

According to a first example of the disclosure, a semiconductor device is disclosed. The semiconductor device comprising a die having a first side and a second side, wherein the die comprises, on a perimeter of the second side, a plurality of die terminals, a central pad having an inner side and an outer side, wherein the central pad comprises an at least one notch, a mold, an non-conductive adhesive layer, wires, at least two lead terminals having an inner side and an outer side, wherein the at least one lead terminal is configured as a long lead terminal. Each of the long lead terminals is placed in the notch. The non-conductive adhesive layer is placed on at least part of the inner side of the central pad and on at least part of the inner side of each of the long lead terminals.

The die is placed on the non-conductive adhesive layer, such that an at least one edge of the die extends beyond at least one edge of the central pad and the die is placed over a part of the inner side of each of the long lead terminals, wherein the first side of the die is facing toward the non-conductive adhesive layer, and preferably the first side of the die is electrically decoupled from the central pad. At least two of the die terminals are electrically coupled with different lead terminals, each to a different lead terminal, by means of the wire, preferably all of the die terminals are electrically coupled with the at least one of the lead terminal, and more preferably every lead terminal is electrically coupled with exactly one die terminal.

The mold encloses the die, the wires, the central pad, all of the at least one lead terminal, such, that the outer side of the central pad and the outer side of all of the at least two lead terminal forms an outer surface of the semiconductor device.

Preferably in each of the at least one notch there is exactly one long lead terminal.

Preferably there are at least two notches, wherein there are at least two edges of the die beneath which the at least one notch is located.

Preferably there are at least four notches, wherein there are four edges of the die beneath which the at least one notch is located.

Preferably wherein the at least one notch has a rectangular shape.

Preferably the at least one lead terminal comprises an inner portion and an outer portion, wherein the outer portion of the at least two lead terminal forms an outer surface of the semiconductor device.

Preferably the central pad comprises an inner portion and an outer portion, wherein the outer portion of the central pad forms an outer surface of the semiconductor device.

Preferably the at least one lead terminal is configured as a short lead terminal, having a shorter length than the long lead terminal.

Preferably every one of the at least one long lead terminal is next to the at least one of the short lead terminal, preferably every one of the at least one long lead terminal is only next to the at least one of the short lead terminal.

Preferably the lead terminal next to a corner of the die is the short lead terminal.

According to a second example of the disclosure a method of manufacturing a semiconductor device is disclosed. The method comprising steps of:
a. providing a lead frame which comprises a central pad having an inner side and an outer side, wherein the central pad comprises an at least one notch, and an least one lead terminal having an inner side and an outer side, wherein the at least one lead terminal is a long lead terminal, wherein each of the long lead terminals is placed in the notch,
b. applying a non-conductive adhesive layer on at least part of a first side of a die,
c. placing the die, having the first side and a second side, wherein the die comprises, on a perimeter of the second side, a plurality of die terminals, on the non-conductive adhesive layer, such that an at least one edge of the die extends beyond an at least one edge of the central pad and the die is placed over a part of the inner side of each of the long lead terminals, wherein the first side of the die is facing toward the non-conductive adhesive layer,
d. connecting the at least two of the die terminals electrically with the lead terminal by means of the wire,
e. enclosing the die, the wires, the central pad, all of the at least one lead terminal with a mold, such, that the outer side of the central pad and the outer side of all of the at least one lead terminal forms an outer surface of the semiconductor device.

Preferably in the step d) all of the die terminals are electrically coupled with the at least one of the lead terminal.

Preferably each lead terminal is electrically coupled with exactly one die terminal

Preferably after the step e) an additional step of a singulation is performed.

### BRIEF DESCRIPTION OF THE DRAWINGS

The disclosure will now be discussed with reference to the drawings, which show in:
Fig. 1A shows a top view of a semiconductor device in a QFN package where a die extends beyond a central pad;
Fig. 1B shows a cross-section of the device shown in Fig. 1A along cross section plane A-A';
Fig. 2A shows an isometric view of a semiconductor device in a QFN package where a die extends beyond a central pad and where the die is also supported with terminal pads;
Fig. 2B shows a top view of a semiconductor device in a QFN package where a die extends beyond a central pad and where the die is also supported with terminal pads, where a first type of notch is shown;
Fig. 2C shows a cross-section of the device shown in Fig. 2B along cross section plane B-B';
Fig. 3A shows a top view of a semiconductor device in a QFN package where a die extends beyond a central pad and where the die is also supported with terminal pads, where a second type of notch is shown;
Fig. 3B shows a cross-section of the device shown in Fig. 3A along cross section plane C-C';
Fig. 4 shows an isometric view of a cross-section of the semiconductor device shown in Fig. 2B and 2C;
Fig. 5 shows an isometric view of a cross-section of the semiconductor device shown in Fig. 3A and 3B;
Fig. 6A shows a bottom view of a semiconductor device in a QFN package where a mold is visible and notches of a central pad are visible on the outer surface of the semiconductor device;
Fig. 6B shows an isometric view of a cross-section of the semiconductor device shown in Fig. 6A;
Fig. 7A shows an isometric view of a DFN package where a die extends beyond a central pad;
Fig. 7B shows an isometric view of a bottom side of a DFN package where a die extends beyond a central pad;
Fig. 7C shows an isometric view of a bottom view of a semiconductor device in a DFN package where a mold is visible;
Fig. 8A shows an isometric view of a lead frame and a die of a semiconductor device;
Fig. 8B shows an isometric view of the bottom side of a lead frame and a die of a semiconductor device.

### DETAILED DESCRIPTION OF THE DISCLOSURE

For a proper understanding of the disclosure, in the detailed description below corresponding elements or parts of the disclosure will be denoted with identical reference numerals in the drawings. Throughout this description phrases "bottom" and "top" refers to the typical orientation of a semiconductor device. The semiconductor device is, in general, designed to be solder to the PCB (printed circuit board) - a side with a terminals which are intended to be soldered to the PCB forms a "bottom" side of the semiconductor device, while other side on which the indication of the semiconductor device are placed and which is normally visible to an observer after the assemble forms a "top" side. Also terms "inner" and "outer" are used. A term "inner" should be understood that any "inner" side, unless provided otherwise, is facing toward a center of the semiconductor device, and any "outer" side is facing outward from the center of the semiconductor device and is visible in a finished semiconductor device unless provided otherwise.

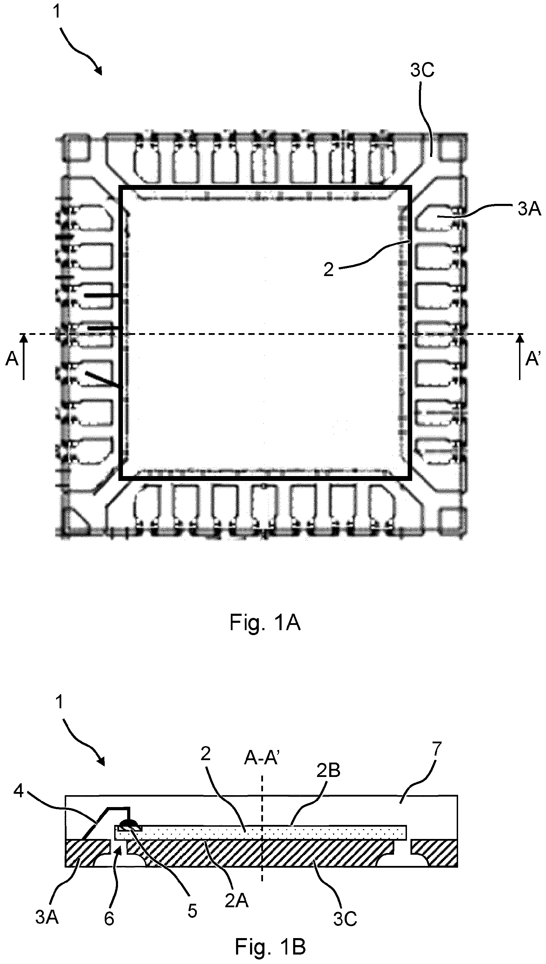

For current quad-flat no-lead (QFN) packages, the maximum die size equals the die pad size. To ensure good die support, the bond pad positions should be supported by full metal. For large dies larger than the die pad, the bond pad positions are not supported by full metal areas as shown Fig 1A and 1B showing die overhang. Die overhang limits the bonding force that can be applied which can cause wire bond process issues such as non-stick on pads, non-optimum welding, and result to yield loss and reliability concerns.

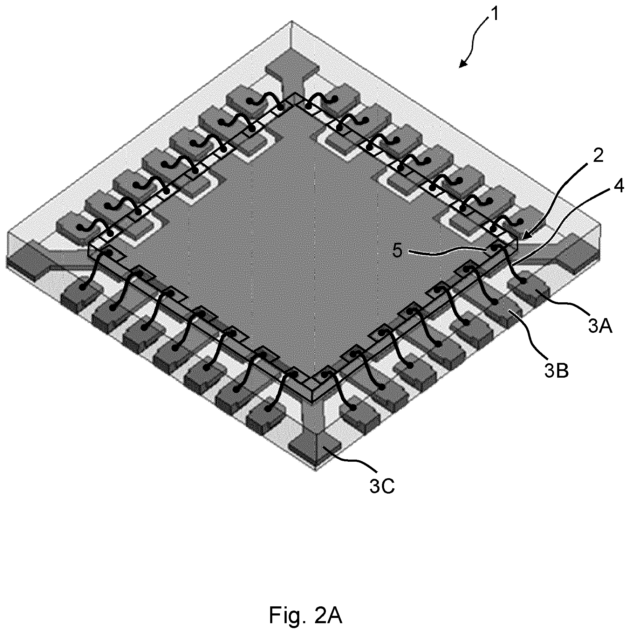

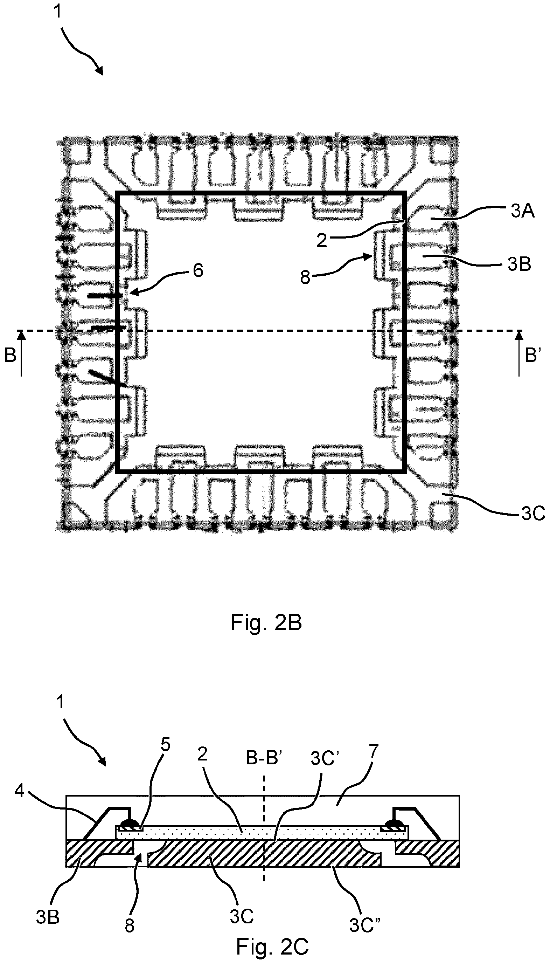

To overcome above mentioned limitations a semiconductor device is disclosed as shown on Fig. 2A. The semiconductor device comprises a die 2, a central pad 3c, an non-conductive adhesive layer, wires 4, and at least two lead terminals 3a, 3b. The die 2 has a first side 2a and a second side 2b, wherein the die 2 comprises, on a perimeter of the second side, a plurality of die terminals 5. The central pad 3c has an inner side and an outer side, wherein the central pad 3c comprises an at least one notch 8. The at least two lead terminals 3a, 3b having an inner side and an outer side, wherein the at least one lead terminal 3a, 3b is configured as a long lead terminal 3b, wherein each of the long lead terminals 3b is placed in the notch 8.

The non-conductive adhesive layer is placed on at least part of the inner side of the central pad 3c and on at least part of the inner side of each of the long lead terminals 3b. The die 2 is placed on the non-conductive adhesive layer, such that an at least one edge of the die 2 extends beyond at least one edge of the central pad 3c and the die 2 is placed over a part of the inner side of each of the long lead terminals 3b. The first side of the die 2 is facing toward the non-conductive adhesive layer. The at least two of the die terminals 5 are electrically coupled with different lead terminals 3a, 3b, each to a different lead terminal 3a, 3b, by means of the wire 4. The mold 7 encloses the die 2, the wires 4, the central pad 3c, all of the at least one lead terminal 3a, 3b, such, that the outer side of the central pad 3c and the outer side of all of the at least two lead terminal 3a, 3b forms an outer surface of the semiconductor device.

As it has been stated the non-conductive adhesive layer is placed on at least part of the inner side of the central pad 3c and on at least part of the inner side of each of the long lead terminals 3b. It should be noted that there are two embodiments possible. In a first one, in which the first side 2a of the die 2 is electrically decoupled from the central pad 3c. In a second one there is a terminal (for example a ground terminal) on the first side 2a of the die 2 and it is electrically coupled with the central pad 3c.

It should be noted that a non-conductive adhesive layer may be pre-applied to the die such that the non-conductive adhesive layer is attach to the whole wafer during a manufacturing. In this case a hole die area is covered with the non-conductive adhesive layer.

In another example all of the die terminals 5 are electrically coupled with the at least one of the lead terminal 3a, 3b, and more preferably every lead terminal 3a, 3b is electrically coupled with exactly one die terminal 5.

In yet another example in each of the at least one notch 8 there is exactly one long lead terminal 3b. In such case there is one notch 8 for every long lead terminal 3b.

In another example there are at least two notches 8, wherein there are at least two edges of the die 2 beneath which the at least one notch 8 is located. Preferably there are at least four notches 8, wherein there are four edges of the die 2 beneath which the at least one notch 8 is located. It should be clear that a term "beneath" means that notches 8 are located at the first side 2a of the die 2.

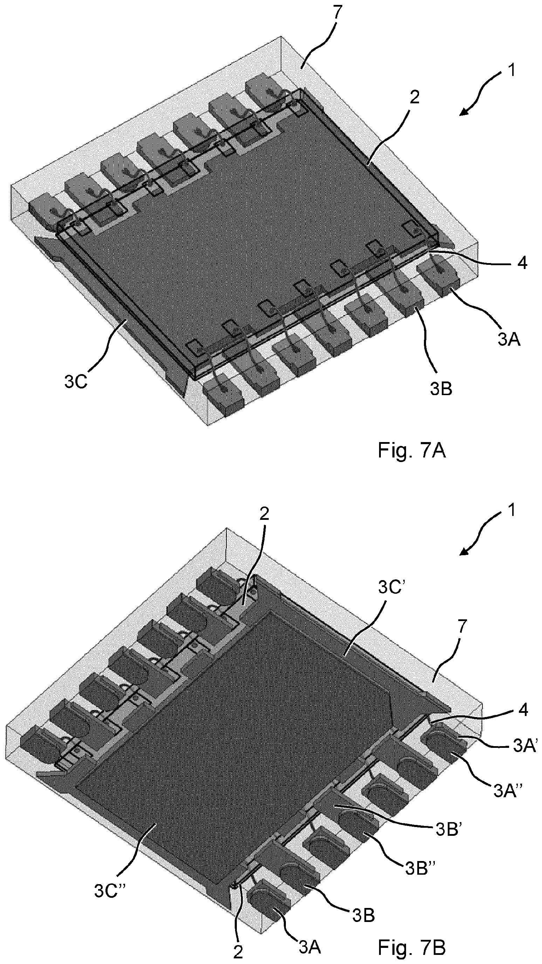

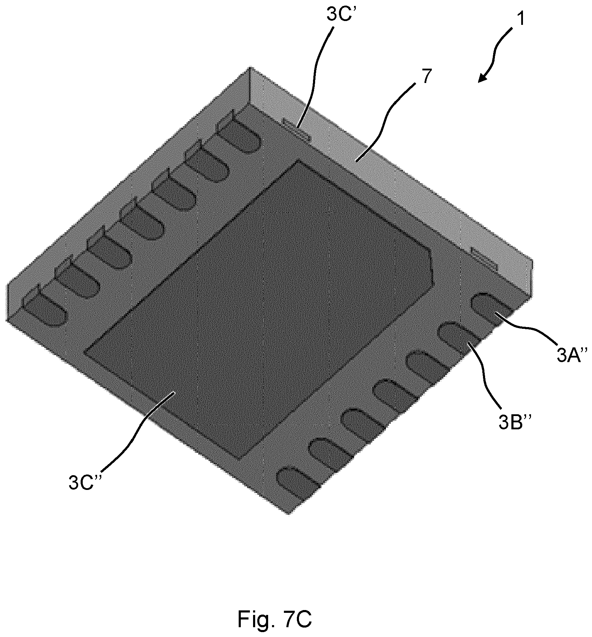

It should be noted that this invention aims toward the semiconductor device in a QFN package, however the person skilled in the art will know that teachings may be applied to other packages, such as dual-flat no-lead (DFN) package. Such example has been shown in Fig. 7A, 7B and 7C.

As it is disclosed in figures the at least one notch 8 has a rectangular shape. The person skilled in the art will know that other shapes are also possible.

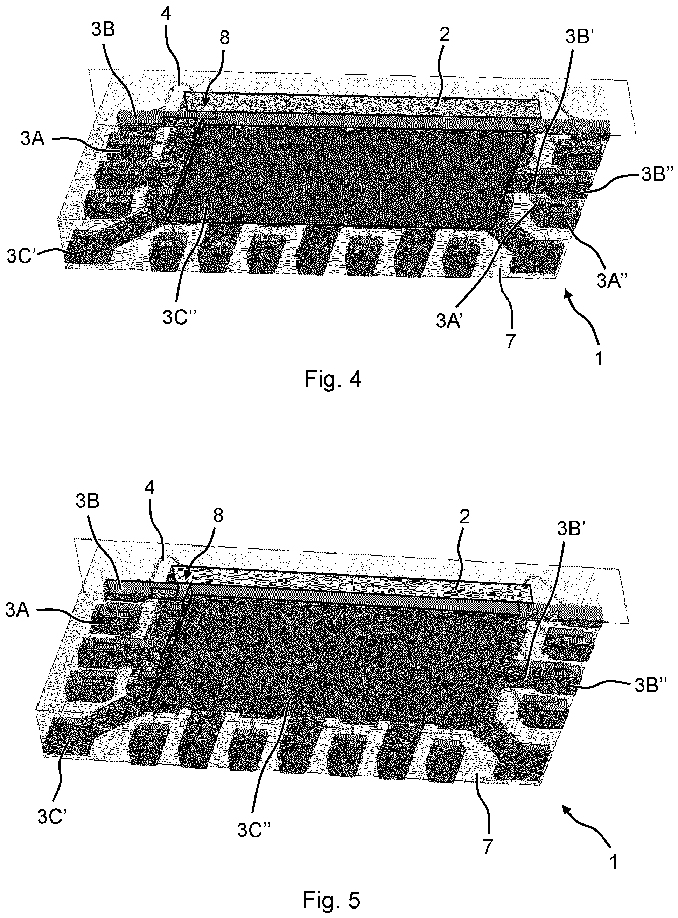

As it may be seen in Fig. 4, 5, 6B, 7B the at least one lead terminal 3a, 3b comprises an inner portion 3a', 3b' and an outer portion 3a", 3b", wherein the outer portion 3a", 3b" of the at least two lead terminal 3a, 3b forms an outer surface of the semiconductor device.

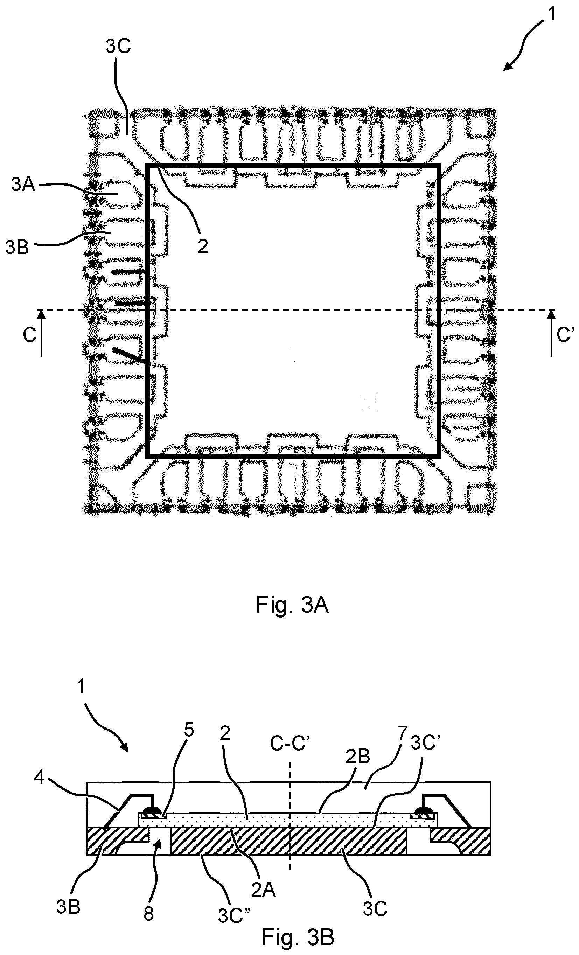

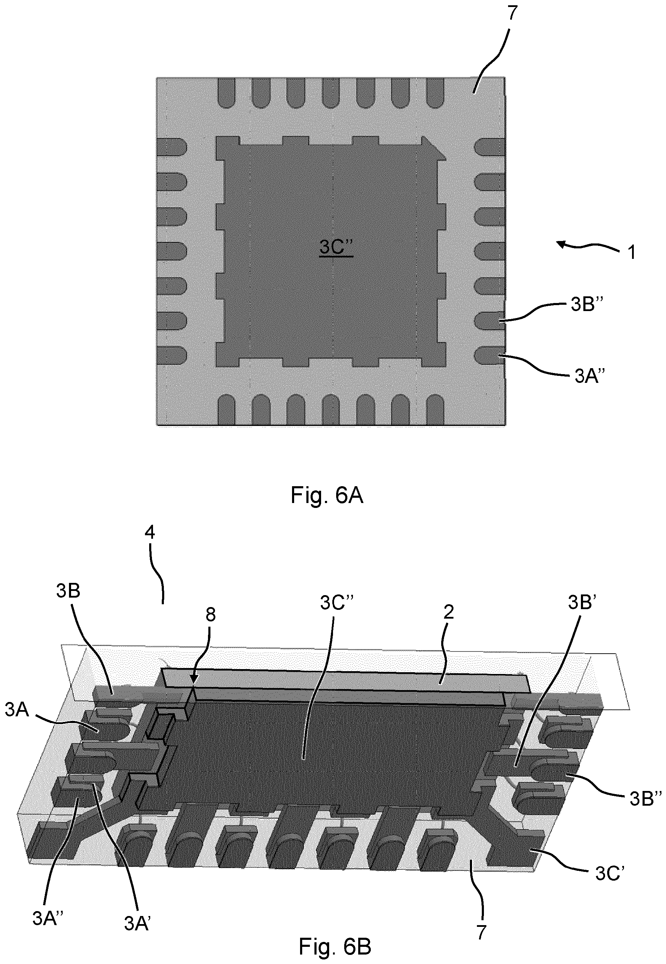

As it may be seen in fig. 2B, 2C, 3A, 3B, 4, 5, 6A, 6B and 7C the central pad 3C comprises an inner portion 3c' and an outer portion 3C", wherein the outer portion 3C" of the central pad 3C forms an outer surface of the semiconductor device. In one example, as may be seen in Fig. 2B the central pad 3C changes shape near the notch 8. An area of the inner portion 3C' is smaller than an area of the outer portion 3C". In Fig. 3B an area of both the inner portion 3c' and the outer portion 3C" is the same and there is no change throughout the central pad 3C. As it may be seen on Fig. 6B An area of the inner portion 3C' is greater than an area of the outer portion 3C". The person skilled in the art will know that many different combination may be used as long as there is enough support for the die 2.

In yet another example the semiconductor device according to anyone of previous claims, wherein the at least one lead terminal 3a, 3b is configured as a short lead terminal 3a, having a shorter length than the long lead terminal 3b.

In another example every one of the at least one long lead termina 3b is next to the at least one of the short lead terminal 3a, preferably every one of the at least one long lead termina 3b is only next to the at least one of the short lead terminal 3a.

In another example the lead terminal next to a corner of the die 2 is the short lead terminal 3a. In a different embodiment the lead terminal next to a corner of the die 2 is the long lead terminal 3b.

A method of manufacturing of a semiconductor according to the invention is also disclosed. A first step, step a, is providing a lead frame 9 which comprises a central pad 3c having an inner side and an outer side, wherein the central pad 3c comprises an at least one notch 8, and an least one lead terminal 3a, 3b having an inner side and an outer side, wherein the at least one lead terminal 3a, 3b is a long lead terminal 3b, wherein each of the long lead terminals 3b is placed in the notch 8. Next, during step b, a non-conductive adhesive layer is applied on at least part of a first side of a die 2.

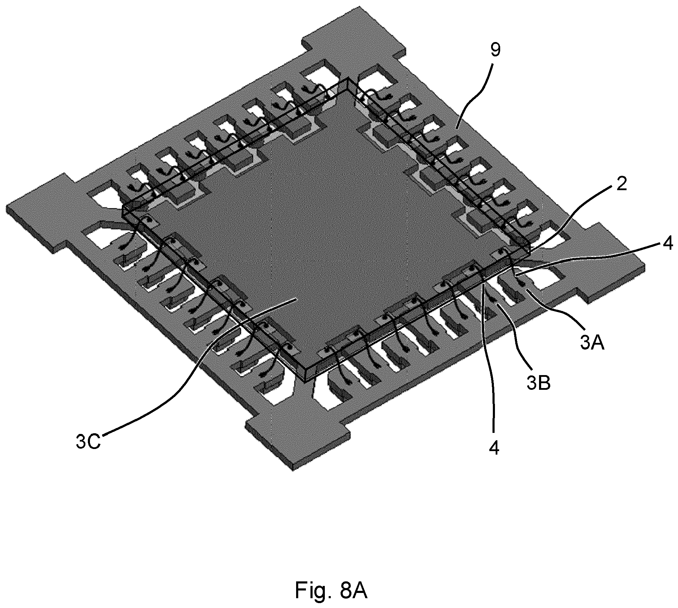

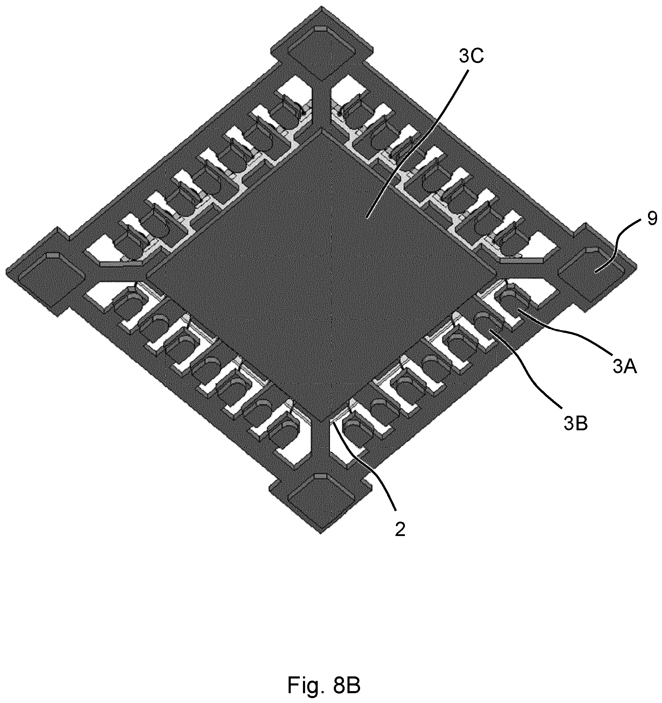

During step c the die 2 is placed, wherein the die 2 has the first side and a second side, wherein the die 2 comprises, on a perimeter of the second side, a plurality of die terminals 5, on the non-conductive adhesive layer, such that an at least one edge of the die 2 extends beyond an at least one edge of the central pad 3c and the die 2 is placed over a part of the inner side of each of the long lead terminals 3b, wherein the first side of the die 2 is facing toward the non-conductive adhesive layer. The lead frame 9 and the die 2 are shown in Fig. 8A and 8B.

During step d at least two of the die terminals 5 electrically with the lead terminal 3a, 3b are connected by means of the wire 4. During a step e the die 2, the wires 4, the central pad 3c, all of the at least one lead terminal 3a, 3b are enclosed with a mold 7, such, that the outer side of the central pad 3c and the outer side of all of the at least one lead terminal 3a, 3b forms an outer surface of the semiconductor device.

In one embodiment in the step d all of the die terminals 5 are electrically coupled with the at least one of the lead terminal 3a, 3b.

In another example each lead terminal 3a, 3b is electrically coupled with exactly one die terminal 5. It should be however noted that not all die terminals 5 have to be connected to the lead terminals 3a, 3b. In another example multiple die terminal 5 may be connected to one lead terminal 3a, 3b.

In yet another example after the step e an additional step of a singulation is performed.

In another example before or after the step of the singulation a step of marking is performed.

### LIST OF REFERENCE NUMERALS USED

- 1: semiconductor device
- 2: die
- 2a: first die side (die bottom side)
- 2b: second die side (die top side)
- 3a: short lead terminal
- 3b: long lead terminal
- 3a'-3b': inner portion of a lead terminal
- 3a"-3b": outer portion of a lead terminal
- 3c: die pad (die pad has connection bars)
- 3c': inner portion
- 3c": outer portion
- 4: wire
- 5: die terminal (bond pads)
- 6: unsupported area
- 7: mould
- 8: notch
- 9: lead frame

## Claims

1. A semiconductor device (1) comprising:
a die (2) having a first side (2a) and a second side (2b), wherein the die (2) comprises, on a perimeter of the second side, a plurality of die terminals (5),
a central pad (3c) having an inner side and an outer side, wherein the central pad (3c) comprises an at least one notch (8),
a mold (7),
an non-conductive adhesive layer,
wires (4),
at least two lead terminals (3a, 3b) having an inner side and an outer side, wherein the at least one lead terminal (3a, 3b) is configured as a long lead terminal (3b),
wherein each of the long lead terminals (3b) is placed in the notch (8),
wherein the non-conductive adhesive layer is placed on at least part of the inner side of the central pad (3c) and on at least part of the inner side of each of the long lead terminals (3b),
wherein the die (2) is placed on the non-conductive adhesive layer, such that an at least one edge of the die (2) extends beyond at least one edge of the central pad (3c) and the die (2) is placed over a part of the inner side of each of the long lead terminals (3b), wherein the first side of the die (2) is facing toward the non-conductive adhesive layer, and preferably the first side of the die (2) is electrically decoupled from the central pad (3c);
where at least two of the die terminals (5) are electrically coupled with different lead terminals (3a, 3b), each to a different lead terminal (3a, 3b), by means of the wire (4), preferably all of the die terminals (5) are electrically coupled with the at least one of the lead terminal (3a, 3b), and more preferably every lead terminal (3a, 3b) is electrically coupled with exactly one die terminal (5) ;
wherein the mold (7) encloses the die (2), the wires (4), the central pad (3c), all of the at least one lead terminal (3a, 3b), such, that the outer side of the central pad (3c) and the outer side of all of the at least two lead terminal (3a, 3b) forms an outer surface of the semiconductor device.

2. The semiconductor device according to claim 1, wherein in each of the at least one notch (8) there is exactly one long lead terminal (3b).

3. The semiconductor device according to claim 1 or 2, wherein there are at least two notches (8), wherein there are at least two edges of the die (2) beneath which the at least one notch (8) is located.

4. The semiconductor device according to claim 3, wherein there are at least four notches (8), wherein there are four edges of the die (2) beneath which the at least one notch (8) is located.

5. The semiconductor device according to anyone of previous claims, wherein the at least one notch (8) has a rectangular shape.

6. The semiconductor device according to anyone of previous claims, wherein the at least one lead terminal (3a, 3b) comprises an inner portion (3a', 3b') and an outer portion (3a", 3b"), wherein the outer portion (3a", 3b") of the at least two lead terminal (3a, 3b) forms an outer surface of the semiconductor device.

7. The semiconductor device according to anyone of previous claims, wherein the central pad (3c) comprises an inner portion (3c') and an outer portion (3c"), wherein the outer portion (3c") of the central pad (3c) forms an outer surface of the semiconductor device.

8. The semiconductor device according to anyone of previous claims, wherein the at least one lead terminal (3a, 3b) is configured as a short lead terminal (3a), having a shorter length than the long lead terminal (3b).

9. The semiconductor device according to claim 8, wherein every one of the at least one long lead terminal (3b) is next to the at least one of the short lead terminal (3a), preferably every one of the at least one long lead terminal (3b) is only next to the at least one of the short lead terminal (3a).

10. The semiconductor device according to claim 9 or 10, wherein the lead terminal next to a corner of the die (2) is the short lead terminal (3a).

11. A method of manufacturing a semiconductor device according to claims 1-10, comprising steps of:
a. providing a lead frame (9) which comprises a central pad (3c) having an inner side and an outer side, wherein the central pad (3c) comprises an at least one notch (8), and an least one lead terminal (3a, 3b) having an inner side and an outer side, wherein the at least one lead terminal (3a, 3b) is a long lead terminal (3b), wherein each of the long lead terminals (3b) is placed in the notch (8),
b. applying a non-conductive adhesive layer on at least part of a first side of a die (2),
c. placing the die (2), having the first side and a second side, wherein the die (2) comprises, on a perimeter of the second side, a plurality of die terminals (5), on the non-conductive adhesive layer, such that an at least one edge of the die (2) extends beyond an at least one edge of the central pad (3c) and the die (2) is placed over a part of the inner side of each of the long lead terminals (3b), wherein the first side of the die (2) is facing toward the non-conductive adhesive layer,,
d. connecting the at least two of the die terminals (5) electrically with the lead terminal (3a, 3b) by means of the wire (4),
e. enclosing the die (2), the wires (4), the central pad (3c), all of the at least one lead terminal (3a, 3b) with a mold (7), such, that the outer side of the central pad (3c) and the outer side of all of the at least one lead terminal (3a, 3b) forms an outer surface of the semiconductor device.

12. The method according to claim 11, wherein in the step d) all of the die terminals (5) are electrically coupled with the at least one of the lead terminal (3a, 3b).

13. The method according to claim 12, wherein each lead terminal (3a, 3b) is electrically coupled with exactly one die terminal (5)

14. The method according to anyone of claims 11-13, wherein after the step e) an additional step of a singulation is performed.

15. The method according to claim 14, wherein before or after the step of the singulation a step of marking is performed.
